# EUROPÄISCHE PATENTANMELDUNG

(11) **EP 1 895 555 A2**
(43) Veröffentlichungstag der Anmeldung: **05.03.2008**
(21) Anmeldenummer: 07112310.3
(22) Anmeldetag: 12.07.2007
(51) Int. Cl.: H01H 9/06, H01H 36/00

(54) **Handwerkzeugmaschine**

(30) Priorität: 30.08.2006 DE 102006040647
(71) Anmelder: ROBERT BOSCH GMBH, 70442 Stuttgart (DE)
(72) Erfinder: Wanek, Helmut, 74366, Kirchheim/Neckar (DE)

(57) **Zusammenfassung**

Die Erfindung beschreibt eine Handwerlczeugmaschine mit mindestens einem kontaktlosen Schaltelement (29; 49), welches zumindest ein Sensorelement (21; 41) und zumindest einen Signalgeber (24; 44) umfasst, und einem Betätigungsmittel (22; 42) zur Betätigung des Schaltelements (29; 49), wobei das Sensorelement (21; 41) oder der Signalgeber (24; 44) mit dem Betätigungsmittel (22; 42) starr verbindbar ist.

## Beschreibung

### Stand der Technik

Die Erfindung betrifft eine Handwerkzeugmaschine nach dem Oberbegriff des Anspruchs 1.

Zum Ein- und Ausschalten werden bei gängigen Elektrowerkzeugen elektromechanische Schalter verwendet, bei denen zwei Kontakte durch mechanische Betätigung miteinander verbunden oder getrennt werden. Entsprechend wird der Stromkreis geschlossen oder unterbrochen. Darüber hinaus sind jedoch auch berührungslos arbeitende Schalter bekannt. So ist in DE 102 59 569 A1 eine Elektrohandwerkzeugmaschine mit einem kontaktlosen elektrischen Handschalter mit einem Betätigungsmittel und einem Sensorschalter beschrieben, wobei der Sensorschalter vibrationsfrei mit einem zumindest schwenkbaren Schaltmittelträger verbunden ist und über ein Schwenkübertragungsmittel in Form einer Drehschwenkkupplung vom Betätigungsmittel händisch steuerbar ist. Durch das Betätigungsmittel in Form eines Schiebeschalters erfolgt über eine Kupplungsführung in Form eines radial zur Schwenkachse verlaufenden Führungsschlitzes eine Bewegungstransformation zwischen dem linear begrenzt versetzbaren Betätigungsmittels und dem drehschwenkbaren Schaltmittelträger. Das Schaltmittel ist als Permanentmagnet, der Sensorschalter als Hall-Sensor ausgeführt.

### Offenbarung der Erfindung

Die erfindungsgemäße Handwerkzeugmaschine umfasst mindestens ein kontaktloses Schaltelement, welches zumindest ein Sensorelement und zumindest einen Signalgeber umfasst. Als kontaktloses oder berührungsloses Schaltelement wird ein Schaltelement angesehen, dessen Kontaktelemente, d.h. Sensorelement und Signalgeber, ohne mechanische Kontaktierung verbunden oder getrennt werden. Das Schaltelement dient vorzugsweise zum Ein- und Ausschalten des Elektromotors der Handwerkzeugmaschine. Mit dem Schaltelement kann aber z.B. auch eine Beleuchtungseinrichtung, z.B. eine Leuchtdiode, zur Beleuchtung des Arbeitsbereichs oder eine andere elektrische oder elektronische Komponente der Handwerkzeugmaschine ein- und ausgeschaltet werden. Weiterhin umfasst die Handwerkzeugmaschine zur Betätigung des Schaltelements ein Betätigungsmittel, welches vom Bediener der Handwerkzeugmaschine händisch betätigbar ist. Eine erfindungsgemäße Schaltvorrichtung umfasst zumindest ein kontaktlos arbeitendes Schaltelement und ein Betätigungsmittel. Erfindungsgemäß ist bei der Handwerkzeugmaschine das Sensorelement oder der Signalgeber mit dem Betätigungsmittel starr verbindbar ausgeführt. Dies ist vorteilhaft, da die Konstruktion der Schaltvorrichtung aus Schaltelement und Betätigungsmittel einfach und aus wenigen Bauteilen aufgebaut. Insbesondere ist im Vergleich zu der in DE 102 59 569 A1 offenbarten Elektrohandwerkzeugmaschine keine Kupplungs- oder Gelenkteile erforderlich, um eine Bewegungstransformation zwischen einem linear bewegbaren Betätigungsmittel und einem drehschwenkbaren Schaltmittelträger zu bewerkstelligen.

In einer ersten Ausführungsform sind das Sensorelement und der Signalgeber linear zueinander bewegbar ausgebildet. Insbesondere sind das Sensorelement und der Signalgeber axial zueinander bewegbar. Durch die lineare, insbesondere axiale, Bewegbarkeit von Sensorelement und Signalgeber zueinander ist eine sichere und genaue Aktivierung bzw. Deaktivierung einer elektrischen oder elektronischen Komponente möglich.

Das Sensorelement und der Signalgeber können dadurch linear, insbesondere axial, zueinander bewegbar ausgeführt sein, dass entweder das Sensorelement ortsfest und der Signalgeber linear, insbesondere axial, bewegbar ist oder der Signalgeber ortsfest und das Sensorelement linear, insbesondere axial, bewegbar ist. Alternativ können auch sowohl das Sensorelement als auch der Signalgeber linear, insbesondere axial, zueinander bewegbar ausgeführt sein. In einer bevorzugten Ausführungsform ist das Sensorelement ortsfest, insbesondere gehäusefest, angeordnet, während der Signalgeber axial bewegbar ausgeführt ist.

Weiterhin ist der Signalgeber bevorzugt gegen die Druckkraft eines Federelements axial bewegbar. Das Federelement ist vorzugsweise eine Schraubenfeder, kann jedoch auch eine andere Art von Federelement, z.B. eine Blattfeder, sein.

In einer bevorzugten Ausführungsform der erfindungsgemäßen Handwerkzeugmaschine ist der Signalgeber mit einem Schieber verbindbar, beispielsweise indem er auf einem Schieber befestigt ist. Dabei ist der Schieber mittels eines Führungselements axial verschiebbar. Ein Führungselement kann z.B. eine Führungshülse oder Führungsschiene sein. Um den Signalgeber axial zu bewegen und damit mit dem Sensorelement in Kontakt zu bringen, ist der Schieber wiederum mit dem Betätigungsmittel verbindbar, das vom Bediener der Handwerkzeugmaschine händisch betätigbar ist. Das Betätigungsmittel ist beispielsweise im Bereich des Handgriffs der Handwerkzeugmaschine so positioniert, dass der Bediener mit einer Hand den Handgriff umgreift und einen Finger der Hand, in der Regel der Zeigefinger, auf das Betätigungsmittel legt. Durch Drücken wird das Betätigungsmittel betätigt, wobei es axial bewegt wird.

Erfindungsgemäß ist das Sensorelement oder der Signalgeber mit dem Betätigungsmittel starr verbunden, wobei vorzugsweise der Signalgeber mit dem Betätigungsmittel über einen Schieber starr verbunden ist. Damit ist auch das Betätigungsmittel axial bewegbar ausgeführt. Der Schieber kann mit dem Betätigungsmittel auf unterschiedliche Weise unlösbar oder lösbar verbunden sein, z.B. durch Kleben, Clipsen, Rasten oder Hintergreifung. Alternativ kann der Schieber auch einstückig mit dem Betätigungsmittel ausgeführt sein. Als Betätigungsmittel wird das Teil angesehen, das von dem Bediener händisch betätigbar ist, unabhängig davon, ob das Betätigungsmittel einteilig oder zweiteilig mit dem Schieber ausgeführt ist. Dies bedeutet zum Beispiel, dass das Betätigungsmittel außerhalb des Gehäuses der Handwerkzeugmaschine angeordnet sein muss, damit es vom Bediener händisch bedienbar ist.

Ein Schaltelement umfasst zumindest ein Sensorelement und zumindest einen Signalgeber. Einem Signalgeber können jedoch auch zwei oder mehrere Sensorelemente zugeordnet sein. Dazu können zwei oder mehrere Sensorelemente nebeneinander angeordnet sein in der Weise, dass der Signalgeber durch axiale Verschiebung die Sensorelemente nacheinander aktiviert. Dabei sind die Sensorelemente in axialer Richtung hintereinander angeordnet. Ein erstes Sensorelement kann dabei beispielsweise für das Ein- und Ausschalten des Elektromotors vorgesehen sein, während ein zweites Sensorelement kann z.B. für das Ein- und Ausschalten einer Beleuchtungseinrichtung, z.B. einer Leuchtdiode, zur Beleuchtung des Arbeitsbereichs eingesetzt werden. Alternativ können auch zwei oder mehrere Sensorelemente so nebeneinander angeordnet sein, dass der Signalgeber durch axiale Verschiebung alle Sensorelemente gleichzeitig aktiviert bzw. deaktiviert. Dies bedeutet, dass die Sensorelemente quer zur axialen Richtung, in der der Signalgeber bewegbar ist, nebeneinander angeordnet sind.

In einer zweiten Ausführungsform der erfindungsgemäßen Handwerkzeugmaschine ist vorgesehen, dass das Sensorelement und der Signalgeber schwenkbar zueinander ausgebildet sind, anstatt linear, insbesondere axial, zueinander bewegbar zu sein. Dies kann so realisiert sein, dass das Sensorelement ortsfest und der Signalgeber schwenkbar ausgebildet ist oder umgekehrt. Bevorzugt ist das Sensorelement gehäusefest angeordnet, während der Signalgeber schwenkbar gelagert ist. Der Signalgeber ist bevorzugt dadurch schwenkbar, dass er mit einem schwenkbar gelagerten Hebel verbunden ist. In einer einfachen Ausführungsform kann der Signalgeber auf dem Hebel befestigt sein. Der Hebel ist wiederum mit dem zweiten Betätigungsmittel verbindbar. Dies kann auf einfache Weise dadurch realisiert sein, dass das zweite Betätigungsmittel an den Hebel angeformt ist. Das zweite Betätigungsmittel kann jedoch auch lösbar oder unlösbar mit dem Hebel z.B. durch Clipsen, Rasten, Hintergreifung oder Kleben verbunden sein. Da erfindungsgemäß die Verbindung zwischen dem Signalgeber und dem Betätigungsmittel starr ausgeführt ist, ist in dieser zweiten Ausführungsform das Betätigungsmittel selbst schwenkbar.

Ein solches schwenkbar ausgebildetes Schaltelement kann z.B. dazu dienen, den Rechts-/Linkslauf der Antriebsspindel der Handwerkzeugmaschine einzustellen.

In einer Weiterbildung der Erfindung ist das Sensorelement auf einer Leiterplatte angeordnet. Auf der Leiterplatte können weitere elektronische Komponenten angeordnet sein. Ferner können auch eine oder mehrere weitere Leiterplatten vorgesehen sein, um die gewünschten elektronischen Komponenten unterzubringen. Die Leiterplatte kann bei einer akkubetriebenen Handwerkzeugmaschine zur Spannungsversorgung mit dem Akkupack über Spannungsleitungen elektrisch verbunden sein. Ferner ist u.a. der Elektromotor mit der Leiterplatte elektrisch über Spannungsleitungen verbunden.

In einer weiteren bevorzugten Ausführungsform ist ein Gehäuse vorgesehen, in dem zumindest das Schaltelement aus zumindest einem Signalgeber und einem Sensorelement aufgenommen ist. Weiterhin können in dem Gehäuse die Leiterplatten sowie andere elektronische Komponenten aufgenommen sein. Das Gehäuse bildet ein separates Gehäuse, welches in dem Gehäuse der Handwerkzeugmaschine angeordnet ist. Es dient insbesondere als Schutz für das Schaltelement und die elektronischen Komponenten auf der Leiterplatte. Ist der Signalgeber über einen Schieber mit dem Betätigungsmittel verbunden, so ragt der Schieber zumindest teilweise in das Gehäuse hinein. An dem Ende des Schiebers, das aus dem Gehäuse herausragt, ist das Betätigungsmittel angeordnet. Das Gehäuse hat außerdem den Vorteil, dass das Gehäuse mit dem Schaltelement, der Leiterplatte, den elektronischen Komponenten sowie dem Schieber und dem Betätigungsmittel zu einem Modul zusammengebaut werden kann und als fertiges Modul in die Handwerkzeugmaschine eingesetzt werden kann. Ist der Elektromotor der Handwerkzeugmaschine ein elektronisch kommutierbarer Elektromotor, so können beispielsweise die elektronischen Komponenten zur Steuerung dieses elektronisch kommutierbaren Elektromotors auf der Leiterplatte angeordnet sein. So bilden das Schaltelement zum An- und Ausschalten des Elektromotors und die elektronischen Komponenten zur Steuerung des Elektromotors eine Einheit in dem separaten Gehäuse. Die Steuerungselektronik für den Elektromotor muss dann nicht mehr separat an einer anderen Stelle im Gehäuse der Handwerkzeugmaschine untergebracht werden.

Vorzugsweise ist zumindest ein Teil des Gehäuses aus Metall. Das Gehäuse kann z.B. zweiteilig aus zwei Halbschalen gebildet sein, wobei ein Gehäuseteil aus Metall und ein Gehäuseteil aus Kunststoff ist. Die beiden Gehäuseteile sind miteinander verbunden, z.B. durch Clipsen. Das metallische Gehäuseteil dient dabei als wärmeleitfähiger Körper, über den die Wärme der elektronischen Komponenten abgeführt werden kann. Dazu kann die Oberfläche des metallischen Gehäuseteils zusätzlich profiliert sein, z.B. in Form von Rippen, Rillen oder andersartigen Erhebungen oder Vertiefungen, die eine Vergrößerung der Oberfläche bewirken.

Ferner kann zusätzlich ein Wärmeleitelement aus Metall vorgesehen sein, welches mit der Leiterplatte einerseits und mit dem Gehäuseteil aus Metall anderseits wärmeleitend verbunden ist. Die wärmeleitfähige Verbindung kann z.B. durch einen wärmeleitfähigen Klebstoff erfolgen. Dies fördert ebenfalls die Abfuhr von Wärme der elektronischen Komponenten auf der Leiterplatte.

In einer bevorzugten Ausführungsform ist das Sensorelement ein Hall-Sensor und der Signalgeber ein Permanentmagnet. Alternativ können jedoch auch andere aktive oder passive Sensorelemente mit einem geeigneten Signalgeber eingesetzt werden, z.B. Sensorelemente, die auf dem piezoelektrischen Effekt oder der elektromagnetischen Induktion beruhen oder kapazitiv, magnetoresistiv, induktiv, galvanomagnetisch oder optisch wirken. Beispielsweise kann als Sensorelement ein Reed-Schalter oder eine Induktionsspule eingesetzt werden, wobei jeweils als Signalgeber ein Permanentmagnet verwendet werden kann. Ein Schaltelement auf optischer Basis kann dergestalt realisiert sein, dass das Sensorelement durch ein System aus einer Leuchtdiode oder einem Fototransistors gebildet wird. Dabei kann der Signalgeber zwischen Leuchtdiode und Fototransistor entweder zur Unterbrechung des Lichtstrahls der Leuchtdiode eine nicht transparente Fläche oder zur Übertragung des Lichtstrahls eine reflexive Fläche für das Licht der Leuchtdiode aufweisen.

Die erfindungsgemäße Handwerkzeugmaschine kann eine netzbetriebene oder akkubetriebene Handwerkzeugmaschine sein. Es kann sich um ein Schrauber, Bohrer, Bohrschrauber, Bohrhammer o.dgl. handeln.

Nachfolgend wird die Erfindung anhand der beigefügten Zeichnungen näher erläutert. Es zeigen
- Figur 1: eine Ausführungsform einer erfindungsgemäßen Handwerkzeugmaschine im Querschnitt
- Figur 2: Teile einer ersten und zweiten Schaltvorrichtung in einer ersten und zweiten Ausführungsform in perspektivischer Darstellung
- Figur 3: einen Längsschnitt durch die Schaltvorrichtungen nach Fig. 2
- Figur 4: einen Querschnitt durch die Schaltvorrichtungen nach Fig. 2.

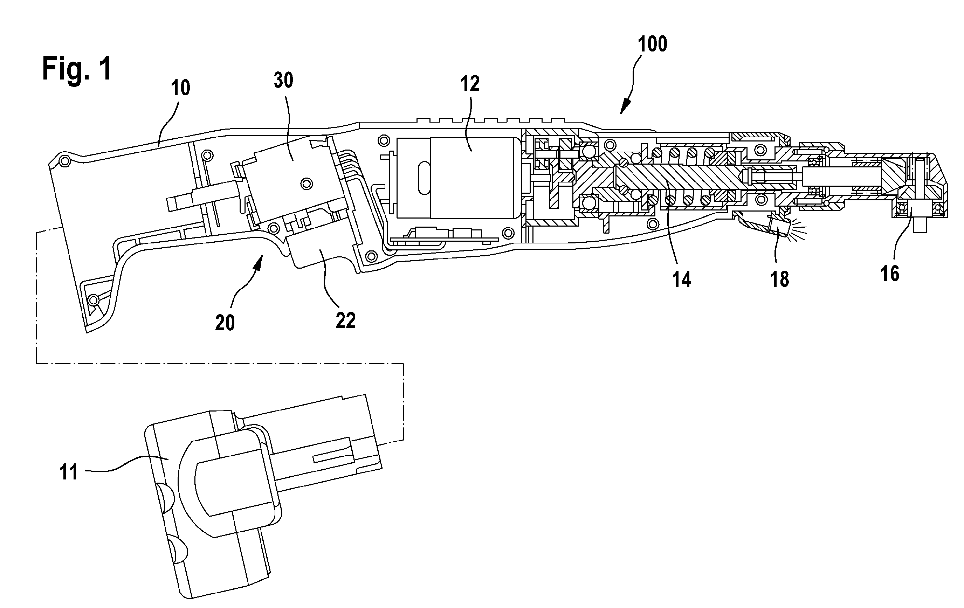

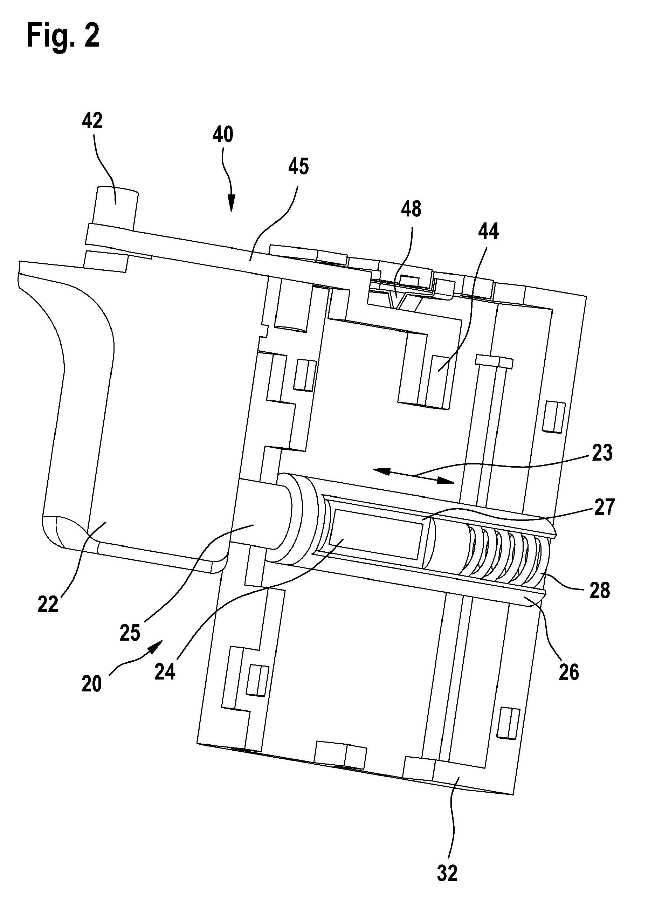

In Figur 1 ist als ein Ausführungsbeispiel einer erfindungsgemäßen Handwerkzeugmaschine 100 ein akkubetriebener Winkelschrauber dargestellt. In dem Gehäuse 10 der Handwerkzeugmaschine 100 ist ein Elektromotor 12 zum Antrieb einer Antriebsspindel 14 untergebracht. Der Elektromotor 12 kann z.B. ein elektronisch kommutierbarer Elektromotor sein. Über die Antriebsspindel 14 wird ein in einer Werkzeugaufnahme 16 aufgenommenes Einsatzwerkzeug (nicht dargestellt) angetrieben. Der Elektromotor 12 wird von einem Akkupack 11 gespeist. Der Akkupack 11 dient ferner zur Spannungsversorgung einer Leuchtdiode, die als Beleuchtungseinrichtung 18 zur Beleuchtung des Arbeitsbereiches der Handwerkzeugmaschine 100 vorgesehen ist. Die Erfindung eignet sich jedoch ebenso für eine netzabhängige Handwerkzeugmaschine. Der Elektromotor 12 und die Beleuchtungseinrichtung 18 sind über eine kontaktlose Schaltvorrichtung 20 mit einem Betätigungsmittel 22 und einem Schaltelement 29, umfassend zwei Sensorelemente 21a und 21b und ein Signalgeber 24 (Fig. 2), in einem Gehäuse 30 aktivierbar bzw. deaktivierbar.

Figur 2 zeigt einen Teil einer ersten Schaltvorrichtung 20 mit dem Schaltelement 29 in perspektivischer Ansicht. Das Gehäuse 30 besteht aus zwei Gehäuseteilen 31, 32 in Form von Halbschalen, von denen in Fig. 2 nur das Gehäuseteil 32 dargestellt ist. In Fig. 2 ist ein linear, hier axial, bewegbarer Signalgeber 24 in Form eines Permanentmagneten gezeigt. Die Bewegungsrichtung des Signalgebers 24 ist durch einen Doppelpfeil 23 angedeutet. Der Signalgeber 24 ist auf einem Schieber 25 befestigt. Der Schieber 25 ist in einem Führungselement 26 in Form einer Führungshülse axial bewegbar angeordnet. Das Führungselement 26 weist im Bereich des Signalgebers 24 eine Öffnung 27, z.B. in Form eines Schlitzes, Fenster o.dgl. auf. Der Schieber 25 ragt zum Teil aus dem Gehäuse 30 heraus. Der Schieber 25 ist außerhalb des Gehäuses 30 mit dem Betätigungsmittel 22, z.B. durch Clipsen, starr verbunden. Damit kann der Schieber 25 axial bewegt werden, indem das Betätigungsmittel 22 von dem Bediener axial in der durch den Doppelpfeil 23 markierten Richtung bewegt wird. Der Schieber 25 ist federbelastet gelagert, so dass beim Betätigen des Betätigungsmittels 22 in Richtung auf das Gehäuse 30 der Schieber 25 gegen die Druckkraft eines Federelements 28, hier einer Schraubenfeder, bewegt wird.

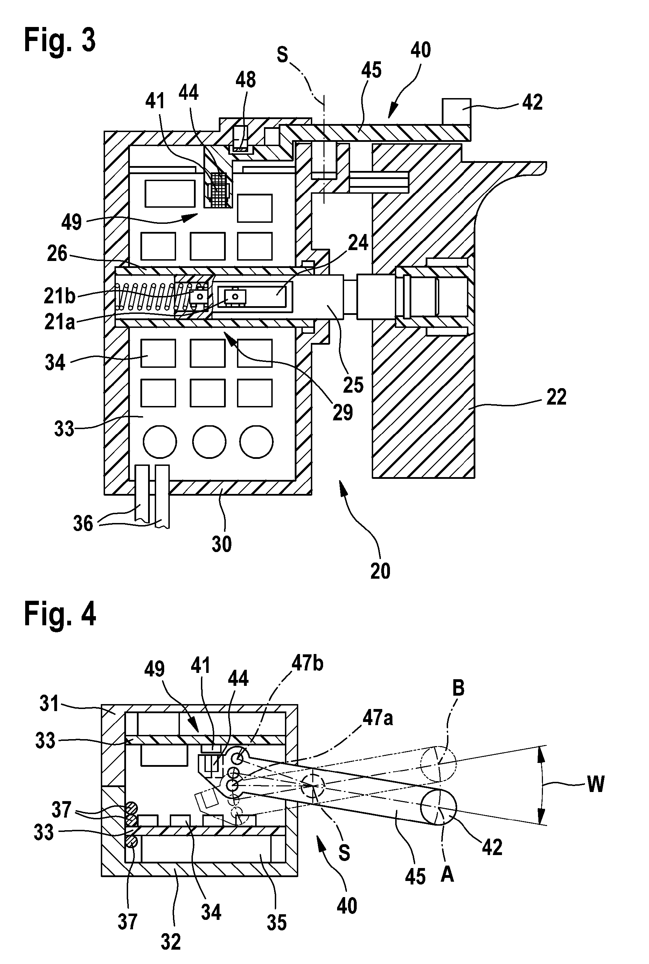

Figur 3 ist zu entnehmen, dass in dem Gehäuse 30 auf Höhe des Schiebers 25 mit dem Signalgeber 24 zwei Sensorelemente 21a und 21b in Form von Hall-Sensoren auf einer Leiterplatte 33 angeordnet sind. Der Signalgeber 24 und die Sensorelemente 21a, 21b bilden das kontaktlose Schaltelement 29. Durch axiales Verschieben des Schiebers 25 in dem Führungselement 26 wird der Signalgeber 24 zunächst mit dem ersten Sensorelement 21 a, dann mit dem zweiten Sensorelement 21b zur Deckung gebracht, wodurch die beiden Sensorelemente 21a und 21b kontaktlos aktiviert bzw. deaktiviert werden. Damit der Signalgeber 24 und das Sensorelement 21 kontaktieren können, ist die Öffnung 27 in dem Führungselement 26 vorgesehen. In der in Fig. 3 dargestellten Position des Schiebers 25 ist gerade das erste Sensorelement 21a mit dem Signalgeber 24 zur Deckung gebracht. Ist der Schieber 25 gegen die Druckkraft des Federelements 28 bis zum Anschlag durchgedrückt, überdeckt der Signalgeber 24 beide Sensorelemente 21a, 21b. In der dargestellten Ausführungsform sind somit zwei Sensorelemente 21a, 21b einem Signalgeber 24 zugeordnet, wobei die Sensorelemente 21a, 21b derart nebeneinander angeordnet sind, dass durch axiales Bewegen des Signalgebers 24 mittels des Betätigungselements 22 die Sensorelemente 21 a, 21b nacheinander aktiviert bzw. deaktiviert werden. Sie sind also in axialer Richtung 23 hintereinander angeordnet. Das erste Sensorelement 21 a dient beispielsweise dazu, die Beleuchtungseinrichtung 18 ein- bzw. auszuschalten, das zweite Sensorelement 21b dazu, den Elektromotor 12 ein- bzw. auszuschalten.

Des Weiteren ist in den Figuren 2-4 eine zweite Schaltvorrichtung 40 in einer zweiten Ausführungsform mit einem Betätigungsmittel 42 und einem kontaktlosen Schaltelement 49 vorgesehen. Das kontaktlose Schaltelement 49 dient der Einstellung des Rechts-/Linkslaufes des Winkelschraubers. Das Schaltelement 49 umfasst ein Sensorelement 41 in Form eines HallSensors und einen Signalgeber 44 in Form eines Permanentmagneten. Das Sensorelement 41 ist wiederum auf einer Leiterplatte 33 angeordnet. Der Signalgeber 44 ist mit einem Hebel 45 verbunden, indem er auf dem Hebel 45 befestigt ist. Der Hebel 45 ragt zum Teil in das Gehäuse 30 hinein. An seinem freien Ende außerhalb des Gehäuses 30 ist der Hebel 45 mit einem Betätigungsmittel 42 versehen, welches der Bediener der Handwerkzeugmaschine 100 händisch betätigen kann. Der Hebel 45 ist schwenkbar gelagert. Er kann um einen Winkel W um eine Schwenkachse S zwischen zwei Positionen A und B geschwenkt werden. In Position A wird der Signalgeber 44 mit dem Sensorelement 41 ohne mechanische Berührung zur Deckung gebracht, wodurch das Schaltelement 49 kontaktlos kontaktiert wird. In Position B sind der Signalgeber 44 und das Sensorelement 41 so weit voneinander beabstandet, dass keine Kontaktierung erfolgt. Ein Federelement 48 ist in dem Gehäuse 30 angeordnet. Es definiert die Endpositionen A und B des Hebels 45, indem der Hebel 45 im Bereich des in das Gehäuse 30 ragenden Endes Vertiefungen 47a und 47 b aufweist, in die das Federelement 48 einrastet.

Auf den Leiterplatten 33 sind weitere elektronische Komponenten 34 angeordnet. Die elektronischen Komponenten 34 können beispielsweise zur Steuerung des elektronisch kommutierbaren Elektromotors 12 dienen. Ist die Steuerungselektronik im Bereich der Schaltvorrichtung 20, 40 angeordnet, hat dies den Vorteil, dass sie sich vergleichsweise weit entfernt von dem Elektromotor 12 befindet und so weniger stark der elektromagnetischer Störstrahlung des Elektromotors 12 ausgesetzt ist. Die Leiterplatten 33 sind durch Spannungsleitungen 36 mit der Spannungsversorgung der Handwerkzeugmaschine 100, z.B. dem Akkupack 11, elektrisch verbunden. Über elektrische Leitungen 37 ist der Elektromotor 12 mit der Leiterplatte 33 elektrisch verbunden. Das Gehäuse 30 umschließt die Schaltelemente 29, 49 sowie die Leiterplatten 33 und die elektronischen Komponenten 34, wodurch die empfindlichen Bauteile besser geschützt sind. Das Gehäuseteil 32 ist aus Metall und kann damit die Wärme, die von den elektronischen Bauteilen entwickelt wird, besser abführen. Zusätzlich ist ein Wärmeleitelement 35 aus Metall vorgesehen, welches mit dem metallischen Gehäuseteil 32 einerseits und der Leiterplatte 33 andererseits wärmeleitend, z.B. mittels eines wärmeleitenden Klebstoffs, verbunden ist.

## Patentansprüche

1. Handwerkzeugmaschine mit mindestens einem kontaktlosen Schaltelement (29; 49), welches zumindest ein Sensorelement (21; 41) und zumindest einen Signalgeber (24; 44) umfasst, und einem Betätigungsmittel (22; 42) zur Betätigung des Schaltelements (29; 49), **dadurch gekennzeichnet, dass** das Sensorelement (21; 41) oder der Signalgeber (24; 44) mit dem Betätigungsmittel (22; 42) starr verbindbar ist.

2. Handwerkzeugmaschine nach Anspruch 1, **dadurch gekennzeichnet, dass** das Sensorelement (21) und der Signalgeber (24) linear, insbesondere axial, zueinander bewegbar sind.

3. Handwerkzeugmaschine nach einem der Ansprüche 1 oder 2, **dadurch gekennzeichnet, dass** das Sensorelement (21) ortsfest, insbesondere gehäusefest, angeordnet ist.

4. Handwerkzeugmaschine nach einem der vorhergehenden Ansprüche, **dadurch gekennzeichnet, dass** der Signalgeber (24) axial bewegbar ausgeführt ist.

5. Handwerkzeugmaschine nach Anspruch 4, **dadurch gekennzeichnet, dass** der Signalgeber (24) gegen die Druckkraft eines Federelements (28) axial bewegbar ist.

6. Handwerkzeugmaschine nach einem der Ansprüche 4 oder 5, **dadurch gekennzeichnet, dass** der Signalgeber (24) mit einem Schieber (25) verbindbar ist, welcher mittels eines Führungselements (26) axial verschiebbar ist.

7. Handwerkzeugmaschine nach Anspruch 6, **dadurch gekennzeichnet, dass** der Schieber (26) mit dem Betätigungsmittel (22) verbindbar ist.

8. Handwerkzeugmaschine nach einem der vorhergehenden Ansprüche, **dadurch gekennzeichnet, dass** mehrere Sensorelemente (21a, 21b) derart nebeneinander angeordnet sind, dass der Signalgeber (24) durch axiale Verschiebung die Sensorelemente (21a, 21b) nacheinander aktiviert.

9. Handwerkzeugmaschine nach Anspruch 1, **dadurch gekennzeichnet, dass** das Sensorelement (41) und der Signalgeber (44) schwenkbar zueinander ausgebildet sind.

10. Handwerkzeugmaschine nach Anspruch 9, **dadurch gekennzeichnet, dass** das Sensorelement (41) ortsfest, insbesondere gehäusefest, angeordnet ist und der Signalgeber (44) schwenkbar gelagert ist.

11. Handwerkzeugmaschine nach Anspruch 10, **dadurch gekennzeichnet, dass** der Signalgeber (44) mittels eines schwenkbar gelagerten Hebels (45) schwenkbar ist.

12. Handwerkzeugmaschine nach Anspruch 11, **dadurch gekennzeichnet, dass** der Hebel (45) mit einem Betätigungsmittel (42) verbindbar ist.

13. Handwerkzeugmaschine nach einem der vorhergehenden Ansprüche, **dadurch gekennzeichnet, dass** das Sensorelement (21; 41) auf einer Leiterplatte (33) angeordnet ist.

14. Handwerkzeugmaschine nach einem der vorhergehenden Ansprüche, **dadurch gekennzeichnet, dass** zumindest das Schaltelement (29; 49) in einem Gehäuse (30) angeordnet ist.

15. Handwerkzeugmaschine nach Anspruch 14, **dadurch gekennzeichnet, dass** zumindest ein Teil (32) des Gehäuses (30) aus Metall ist.

16. Handwerkzeugmaschine nach Anspruch 15, **dadurch gekennzeichnet, dass** ein Wärmeleitelement (35) vorgesehen ist, welches die Leiterplatte (33) mit dem Gehäuseteil (32) aus Metall verbindet.

17. Handwerkzeugmaschine nach einem der Ansprüche 13-16, **dadurch gekennzeichnet, dass** auf der Leiterplatte (33) elektronische Komponenten (34) zur Steuerung eines elektronisch kommutierbaren Elektromotors (12) vorgesehen sind.

18. Handwerkzeugmaschine nach einem der vorhergehenden Ansprüche, **dadurch gekennzeichnet, dass** das Sensorelement (21; 41) ein Hall-Sensor und der Signalgeber (24; 44) ein Permanentmagnet ist.
